Europäisches Patentamt

**European Patent Office**

**Office européen des brevets**

(11) Numéro de publication: **0 010 507**
A1

# DEMANDE DE BREVET EUROPEEN

(21) Numéro de dépôt: **79400789.8**

(22) Date de dépôt: **24.10.79**

(51) Int. Cl.³: **G 02 B 7/26**
**H 01 L 31/02**

(30) Priorité: **25.10.78 FR 7830283**

(43) Date de publication de la demande:
**30.04.80 Bulletin 80/9**

(84) Etats Contractants Désignés:
**BE DE GB IT NL**

(71) Demandeur: **SOURIAU & Cie (S.A.)**
**9/13, rue du Général Galliéni**
**F-92103 Boulogne-Billancourt(FR)**

(72) Inventeur: **Prunier, Jean-Claude**
**16 bis, Avenue Foch Résidence "Les Pierges"**
**F-95220 Herblay(FR)**

(74) Mandataire: **Berogin, Francis**
**Société S.E.D.I.C. 21, rue Molière**
**F-92120 Montrouge(FR)**

(54) Connecteur de connexion d'une fibre optique et d'une photodiode.

(57) Le connecteur assurant la connexion d'une fibre optique
(45) et d'une photodiode est constitué d'une embase (15),
dont une extrémité tubulaire (21) reçoit une fiche (22) portant
un embout (25), au bout duquel est immobilisée l'extrémité de
la fibre (45), et qui est monté flottant dans la fiche (22). Celleci
et l'embout (25), sont immobilisés en rotation vis-à-vis de
l'embase (15), et l'embout (25) est appliqué axialement par
des moyens élastiques contre la fenêtre (11) d'une photodiode de l'embout-récepteur, dont le corps, constitue simultanément le corps de la photodiode, et dont la position vis-à-
vis de l'embase (15) est réglable dans un plan radial.

EP 0 010 507 A1

./....

FIG.3

1

# CONNECTEUR DE CONNEXION D'UNE FIBRE OPTIQUE ET D'UNE PHOTODIODE

L'invention a pour objet un connecteur optique destiné à assurer la connexion d'une fibre optique émettrice à une photodiode réceptrice.

Les photodiodes généralement utilisées sont essentiellement constituées d'un cristal sensible, de petite taille, se présentant sous la forme d'un cylindre de faible hauteur, disposé sur un substrat en céramique, lui-même reçu sur un support métallique, fixé dans un corps de boîtier fermé par un capot de protection, de forme générale cylindrique, et portant une fenêtre en verre, à l'aplomb du cristal sensible, pour permettre à ce dernier de recevoir un signal lumineux traversant la fenêtre. Les deux faces du cristal sensible sont chacune reliée par une connexion électrique à une borne de contact traversant de façon étanche le support, un signal électrique, correspondant au signal lumineux reçu par le cristal, étant ainsi recueilli sur les bornes.

L'utilisation des photodiodes connues de ce type, portées par un embout-récepteur d'un signal lumineux émis par une fibre optique appliquée contre la fenêtre de la photodiode dans des connecteurs, connus à cet effet, présente un inconvénient majeur. En effet, si $R_c$ est le rayon du coeur de la fibre optique émettrice, si $\propto$ est l'ouverture numérique de cette fibre (en général de l'ordre de 18 ou 19°), et si e est la distance séparant l'extrémité de la fibre du cristal, le rayon $R_E$ de la tache de lumière émise par la fibre optique et projetée sur le cristal récepteur est donné par la formule :

$$R_E = Rc + e \, tg \propto$$

ce qui, compte tenu de la valeur de la distance e dans les photodiodes usuelles, donne une valeur supérieure à celle du rayon $R_R$ du cristal récepteur.

Une partie de la lumière émise ne parvient donc pas sur le cristal, et se trouve ainsi perdue, les pertes de transmission atteignant 1,5 décibel (db), ce à quoi s'ajoutent les pertes dues aux réflexions de Fresnel dans le dioptre verre-air entre la fenêtre et le cristal, et les pertes dues à l'écart de centrage $\triangle xy$ entre l'axe x de la fibre et l'axe y du cristal.

On obtiendra une bonne transmission du signal si le rayon du cristal récepteur utilisé $R_R$ vérifie l'inégalité $R_R \geqslant R_E + \triangle xy$, l'écart $\triangle xy$ étant défini par les jeux de montage, d'une part, de la fibre sur un embout-émetteur du connecteur, et de l'embout-émetteur sur l'embase du connecteur, d'autre part, du cristal sur l'embout-récepteur, et de l'embout-récepteur sur l'embase du connecteur.

Pour remédier à ces inconvénients, il a déjà été proposé, notamment par le brevet US 4,024,397 de fermer le boîtier d'un élément photorécepteur non plus par un capot de protection portant la fenêtre, mais directement par la fenêtre fixée par son pourtour dans une gorge circulaire pratiquée dans le corps de boîtier, de telle sorte que la face de la fenêtre tournée vers le cristal soit à une faible distance de ce cristal. Ceci est obtenu, soit en découpant la partie gênante du capot de protection, soit en supprimant ce dernier.

Par ailleurs, on connait par le brevet US 3,954,338, un connecteur fibre-diode dans lequel, l'extrémité libre d'une portion de fibre optique, dépassant
d'un embout dans lequel une portion adjacente de
la fibre est enserrée, est au contact de la fenêtre de la diode, portée par un support constitué
par un goujon monté sur un embout-récepteur vissé
sur une embase. Une fiche dans laquelle est reçu
l'embout, dont la position axiale, vis-à-vis de la
fiche est définie au moyen d'une vis de réglage,
est elle-même reçue à l'intérieur d'un manchon de
matière élastique et déformable, dont la position
dans l'embase est définie au moyen de vis de réglage radial. Ce connecteur présente, comme inconvénients, le fait que la portion de la fibre dépassant de l'embout n'est pas du tout protégée avant
le montage de la fiche dans l'embase, et que les
différents composants du connecteur doivent vérifier simultanément de nombreuses conditions géométriques, notamment la diode doit être coaxiale à
son goujon-support, lui-même monté coaxialement
sur l'embout-récepteur, et ce dernier est coaxial
à l'embase lorsqu'il lui est solidaire, tandis que
l'embout, le manchon d'insertion de la fibre, et la
fiche doivent être coaxiaux l'un à l'autre. Pour
ces raisons, un tel connecteur est utilisable en
laboratoire, mais ne peut être communément utilisé
sur chantier, du fait de sa fragilité, des coûts
de réalisation et du fait que l'un quelconque des
trois éléments de base du connecteur que sont
l'embout-récepteur, la fiche et l'embase, ne peut
être combiné à l'un des deux autres éléments tirés
chacun d'une famille d'éléments standards.
On connait également, par le brevet US 3,932,761
un module d'accouplement d'une fiche et d'une diode,
dans lequel un morceau de fibre collé par une ex-

4

trémité dans l'alésage central d'un embout lui-même collé sur une fiche, est directement en contact, par son autre extrémité, avec le cristal sensible d'une diode disposée sur un support conducteur retenu par une colle électriquement isolante dans un corps d'embase conducteur, sur lequel se vissent d'un côté la fiche, et de l'autre côté un embout-récepteur, protégeant l'extrémité du support conducteur. Ce module ne constitue pas un connecteur dont une fiche et un embout-récepteur peuvent être aisément et successivement connectés à ou déconnectés d'une embase, mais un élément intermédiaire dont l'embout doit coopérer avec celui d'un connecteur fibre à fibre, et dont l'embout-récepteur doit coopérer avec celui d'un connecteur électrique, ce qui rend irrationnelle son utilisation sur chantier.

On connait, de plus, par le brevet US 4,118,105 et la demande de brevet français 2.356.167 des connecteurs fibre-diode, du type de celui faisant l'objet de la présente invention, et comprenant une embase, dont l'une des extrémités, de forme générale tubulaire, est destinée à recevoir une fiche portant un embout, lequel présente un perçage longitudinal dans lequel est reçue la fibre retenue, par son extrémité, à une extrémité de l'embout qui est reçue, au montage de la fiche sur l'embase, dans un alésage central de l'embase, l'autre extrémité de l'embase recevant un embout-récepteur équipé d'une photodiode.

Dans le brevet US 4,118,205, l'embout est centré coaxial sur la fiche, à laquelle il est lié par collage ou par vissage, la fiche étant elle-même montée coulissante coaxialement sur l'embase, tandis

5

que la photodiode, d'un type classique, dont le corps de boîtier enveloppant un support traversé par des bornes de contact reliées à un cristal sensible, est fermé par une fenêtre, et se trouve disposé dans l'embout-récepteur constitué sous la forme d'un manchon isolant, lui-même positionné axialement à l'aide de cales, de rondelles et d'une vis de réglage à l'intérieur d'un perçage fileté de l'embase. Cette solution présente l'inconvénient que rien n'est prévu pour assurer de façon simple le positionnement radial de l'embout-récepteur dans le perçage fileté de l'embase, et qu'un positionnement axial convenable de la fibre par rapport à la diode n'est pas assuré, de sorte qu'il est nécessaire de prévoir une lentille à la place de ou sur la fenêtre de la diode pour remédier aux inconvénients résultant de la distance non négligeable qui peut alors séparer l'extrémité de la fibre du cristal sensible de la diode. De même, dans la demande de brevet français 2.356.167, la fenêtre de la photodiode est remplacée par un générateur d'images à l'entilles dont une extrémité est très proche du cristal sensible, voire même reliée à ce dernier par une goutte de liquide intersticiel d'indice de réfraction convenable, tandis que son autre extrémité n'est pas en contact de la fibre du fait du léger retrait de celle-ci dans l'embout qui la porte, et du fait du montage du générateur d'images à lentilles, dans un fourreau cylindrique en butée contre un épaulement interne de l'embout-récepteur, par l'effet d'une vis de réglage sur le boîtier de la photodiode sur lequel le fourreau cylindrique est soudé.

Du fait des coûts de réalisation, notamment des blocs optiques, et des difficultés de mise en oeuvre, pour obtenir notamment un positionnement radial correct de la fibre et de la photodiode, ces dispositifs ne sont pas aptes à l'exploitation à grande échelle sur chantiers, mais se prêtent uniquement à l'utilisation en laboratoires.

Par la présente invention, on s'est proposé d'adapter les connecteurs du type présenté ci-dessus, afin de les rendre utilisables à grande échelle sur chantiers, en simplifiant leur structure, de façon à obtenir le double avantage d'un coût de réalisation acceptable et d'une mise en oeuvre aisée, tout en bénéficiant de bonnes possibilités de réglage radial et de positionnement axial de la fibre par rapport à la photodiode.

A cet effet, le connecteur selon l'invention se caractérise en ce que l'embout, monté flottant dans la fiche avec un jeu supérieur au jeu de montage de la fiche dans l'embase dans laquelle la fiche est immobilisée en rotation, est lui-même immobilisé en rotation dans l'alésage central de l'embase, et se trouve appliqué axialement, par des moyens élastiques contre la fenêtre de la photodiode de l'embout-récepteur dont la position vis-à-vis de l'embase est réglable dans un plan radial.

Avantageusement, pour supprimer le jeu de montage de la photodiode dans l'embout-récepteur et pour améliorer la réception par la photodiode du signal lumineux issu de la fibre, la fenêtre de la photodiode est fixée, par son pourtour dans une gorge pratiquée directement dans le corps de l'embout-récepteur, constituant simultanément le corps du boîtier de la photodiode, et susceptible d'être positionné contre l'autre extrémité de l'embase au moyen d'éléments de centrage filetés.

Dans une forme particulière de réalisation, le corps de l'embout-récepteur présente des perçages destinés à être traversés, avec un jeu important, par les éléments de centrage filetés, lesquels sont susceptibles d'être vissés dans des perçages filetés présentés par l'extrémité de l'embase recevant l'embout-récepteur.

Dans une autre forme particulière de réalisation, l'extrémité de l'embase recevant l'embout-récepteur est également de forme tubulaire, entoure le corps du boîtier de la photodiode de l'embout-récepteur, et présente un filetage interne sur lequel vient se visser un obturateur, éventuellement traversé par les deux bornes de contact de la photodiode, et dans lequel ont été ménagés des perçages filetés recevant des éléments de centrage filetés, dont l'extrémité, saillant de l'obturateur du côté de l'embase, applique et positionne le corps de l'embout-récepteur contre l'embase.

Pour permettre le positionnement de l'embout-récepteur vis-à-vis de l'embase, au moyen d'un micromanipulateur, et avant le serrage des éléments de centrage filetés, au moins un orifice est avantageusement ménagé dans l'extrémité de forme tubulaire de l'embase entourant l'embout-récepteur.

La présente invention sera mieux comprise à l'aide d'exemples particuliers de réalisation de connecteurs selon l'invention, décrits en référence aux figures annexes où :

- la figure 1 représente une photodiode obtenue à partir d'une photodiode classique, par découpage du capot de protection portant la fenêtre et représenté en pointillés.

- la figure 2 représente un schéma, faisant appa-

8

raître 1 s conditions géométriques à respecter et ci-dessus évoquées.

- la figure 3 représente une vue en coupe axiale d'un premier exemple de connecteur muni d'un embout-récepteur équipé d'une photodiode,

- et la figure 4 représente une vue en coupe partielle, analogue à la figure 3, pour un second exemple de connecteur muni d'un embout-récepteur équipé d'une photodiode.

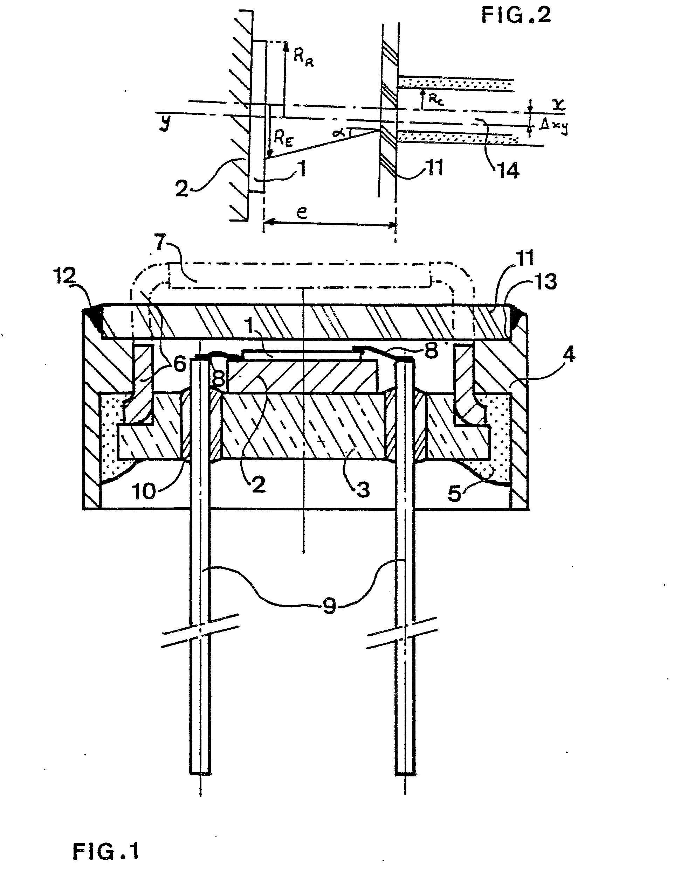

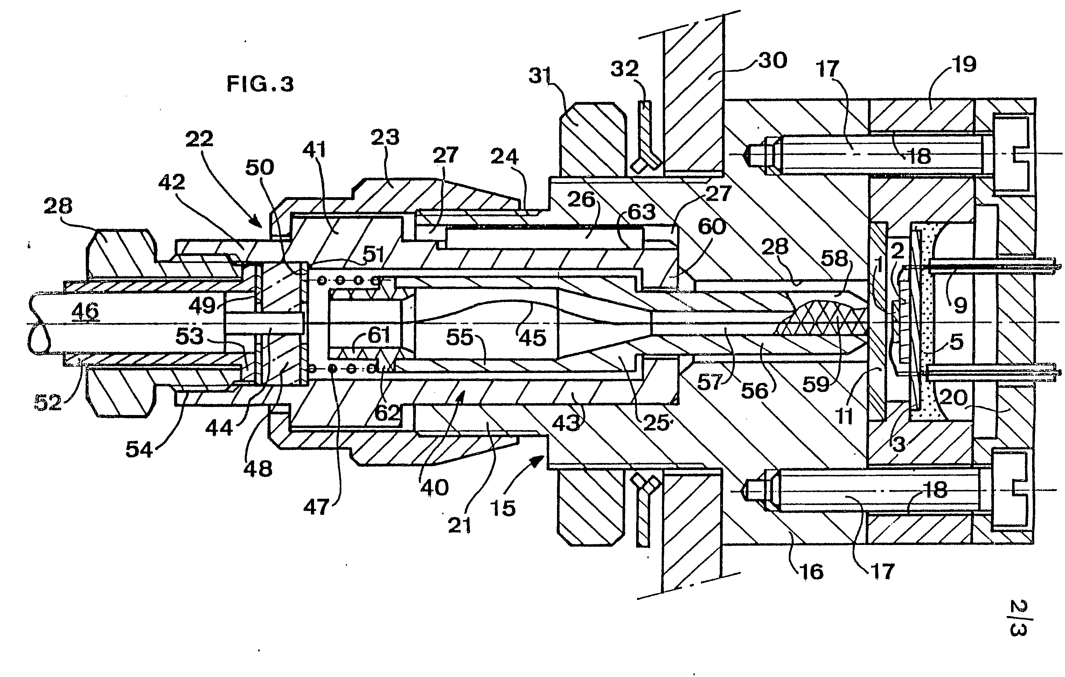

En référence à la figure 1, la photodiode est constituée d'un cristal sensible 1, appliqué contre un substrat en céramique 2, fixé sur un support métallique 3, solidarisé à un corps de boîtier 4 par un bloc de colle 5, en pinçant, contre le corps de boîtier 4, un capot de protection 6 qui, dans les photodiodes usuelles, maintient une fenêtre de verre ou de silice 7. Le cristal 1 est relié par des connexions électriques 8 à deux bornes de contact 9 fixées au support 3 qu'elles traversent par deux bouchons isolants 10. Dans la photodiode avantageusement utilisée, la fenêtre 11 est solidarisée par le dépôt de colle 12 dans une gorge circulaire 13 pratiquée directement dans le corps de boîtier 4 : la fenêtre 11 se trouve ainsi rapprochée du cristal 1, de telle sorte que le rayon $R_R$ du cristal 1 soit supérieur ou égal au rayon $R_E$ de la tache de lumière projetée par la fibre optique 14 sur le cristal 1, augmenté du désaxage $\triangle xy$ (voir figure 2). Ceci est obtenu, sur la figure 1, en découpant la partie du capot 6 qui porte la fenêtre 7, mais il est également possible, comme montré sur la figure 3, de supprimer totalement le capot 6. Si, de plus, un dépôt anti-reflet est vaporisé sur la fenêtre 11, on peut ramener les pertes de Fresnel à une valeur de l'ordre de 0,2 db, un écart de centrage étant autorisé compte-tenu de ce que l'inégalité exprimée ci-dessus reste vérifiée.

Le connecteur représenté sur la figure 3, destiné à assurer la connexion d'une fibre optique et d'une photodiode, est constitué d'une embase 15 dont une extrémité massive 16 présente deux perçages filetés dans lesquels sont reçues deux vis 17 traversant, avec un jeu important, deux perçages 18 ménagés dans un corps d'embout-récepteur 19, constituant simultanément le corps de boîtier d'une photodiode analogue à celle de la figure 1 et dont les composants correspondants portent les mêmes indices, le corps d'embout-récepteur 19 étant appliqué par un obturateur 20 contre l'embase 15 sous l'effet du serrage des vis 17. L'autre extrémité 21 de l'embase 15 est de forme générale tubulaire, et peut recevoir une fiche 22 se fixant sur l'embase 15 par vissage de l'écrou de connexion 23 sur un filetage externe 24 de l'extrémité tubulaire 21 de l'embase 15. La fiche 22 est munie d'un embout 25 sur lequel est fixé l'extrémité d'une fibre optique émettrice. Comme cela est décrit et représenté en détail dans la demande de brevet européen n° 79400775.7 au nom de la Demanderesse, à laquelle on se reportera pour obtenir toutes précisions sur les structures d'un embout tel que 25 et d'une fiche telle que 22, ainsi que sur un dispositif de montage d'une fibre sur un embout tel que 25, directement utilisable sur une fiche telle que 22, et sur différents moyens assurant la retenue dans la fiche de l'embout, la fiche 22 comprend un corps de fiche 40, constitué d'un épaulement 41 de retenue de l'écrou de connexion 23, de part et d'autre duquel se trouvent deux portions tubulaires 42 et 43, dont l'une 42 est destinée à recevoir des moyens de retenue d'une gaine 44 entourant une fibre optique 45, et d'une câble 46 de protection mécanique de la gaine 44, et dont l'autre 43, est destinée à loger un embout 25 et un ressort 47. Les moyens de retenue de la gaine 44 sont constitués par un presse-étoupe 48 présentant un perçage central et disposé entre deux rondelles 49 et 50, dont l'une 50 est appliquée contre l'épaulement interne 51 du corps de fiche 40. Les moyens de retenue du câble 46 sont constitués par une ferrule 52 à sertir ou sertie autour du câble 46 et dont une extrémité 53 est pincée entre la rondelle 49 et un écrou serre-câble 28 qui se visse sur le filetage 54 interne à l'extrémité de la portion tubulaire 42 du corps de fiche 40. Par le vissage de l'écrou serre-câble 28, on assure simultanément la retenue de la ferrule 52 sertie autour du câble 46 et la compression, entre les rondelles 49 et 50, du presse-étoupe 48 qui enserre et retient la gaine 44. L'embout 25 est constitué d'une base creuse 55, traversée par une partie dénudée de la fibre optique 45, et portant un canon 56 de section carrée ou rectangulaire, à bords chanfreinés, présentant un perçage longitudinal 57 dans lequel débouche une fente d'extrémité 58, l'extrémité de la fibre optique 45 étant reçue dans le perçage longitudinal 57 du canon 56 et étant immobilisée à son extrémité par un bloc de colle 59, préalablement introduit par la fente 58, comme cela est expliqué dans la demande de brevet européen évoquée ci-dessus. L'embout 25 est monté dans le corps de fiche 40 de telle sorte que la base 55 soit reçue dans la portion tubulaire 43 et que le canon 56 traverse un fond 60 du corps de fiche 40, la base 55 étant susceptible de coulisser dans la portion tubulaire 43 à l'encontre du ressort 47, prenant appui, d'un côté, contre la rondelle 50, et, de l'autre, contre la butée annulaire 62 d'un manchon 61 traversé par la fibre 45, reçu dans l'extrémité libre de la base 55 de l'embout 25, et faisant office de limiteur de course pour les mouvements de recul de l'embout 25 dans le corps de fiche 40, qui, s'ils étaient trop importants, notamment lors des manipulations de la fiche 22 avant la connexion sur l'embase 15, conduiraient à des surcharges et à un flambage excessif de la partie de la fibre 45 située dans la base 55, pouvant mener à une cassure de la fibre 45 ou au développement sur la fibre de microcourbures apportant des pertes d'insertion.

Le corps de fiche 40 comporte également, sur sa portion tubulaire 43, un logement 63 pour une clavette 26. Lorsqu'on assemble sur l'embase 15, la fiche 22 sur laquelle on a préalablement monté un embout 25, retenant l'extrémité à connecter d'une fibre 45, ainsi que le ressort 47 et les divers moyens de retenue du câble 46 et de la gaine 44, la portion tubulaire 43 est introduite dans l'extrémité tubulaire 21 de l'embase 15, la clavette 26 se logeant dans une rainure 27 de l'embase 15 et empêchant toute rotation relative du corps de fiche 40 dans l'embase 15. Le corps de fiche 40, l'embase 15 et l'embout 25 sont réalisés de sorte que le jeu de montage de l'embout 25 dans la fiche 22 soit supérieur au jeu de montage de la fiche 22 dans l'embase 15. Le canon 56, de section carrée ou rectangulaire, à bords chanfreinés de l'embout 25, ainsi monté "flottant" sur la fiche 22, se trouve reçu, au montage de la fiche 22 sur l'embase 15, dans un alé-

0010507

12

sage central 28 de l'embase 15.

Ainsi, en position de connexion, soit après vissage de l'écrou 23 sur le filetage 24 de l'embase 15, la fiche 22 et l'embout 25 sont respectivement immobilisés en rotation vis-à-vis de l'embase 15, et le canon 56 de l'embout 25 est appliqué par le ressort 47 contre la fenêtre 11 de la photodiode, dans une position par rapport à l'embase 15 librement occupée vis-à-vis de la fiche 22, le recul élastique de l'embout 25 dans le corps de fiche 40 évitant les éventuelles surpressions de contacts, qui seraient dommageables pour la fibre 45, dont l'extrémité, retenue dans l'extrémité du canon 56 de l'embout 25, est également appliquée contre la fenêtre 11, et pour cette fenêtre 11 elle-même.

La fiche 22 étant montée sur l'embase 15 immobilisée contre le support 30 par l'écrou 31 serrant la rondelle 32, et les vis 17 étant déserrées, on déplace le corps d'embout-récepteur 19 sur l'embase 15 jusqu'à obtenir la meilleure transmission entre la fibre optique et le cristal 1 de la photodiode, puis l'on serre les vis 17 pour immobiliser l'embout-récepteur dans cette position.

On obtient ainsi que le positionnement axial de l'embout 25 est convenablement assuré contre la fenêtre 11 de la photodiode par le ressort 47, tandis que le positionnement radial de l'embout 25 est défini par son positionnement par rapport à l'embase 15. La position de l'embout-récepteur vis-à-vis de l'embase 15 étant réglable dans un plan radial, il est aisé d'immobiliser l'embout-récepteur dans la position de meilleure transmission entre la fibre et la photodiode.

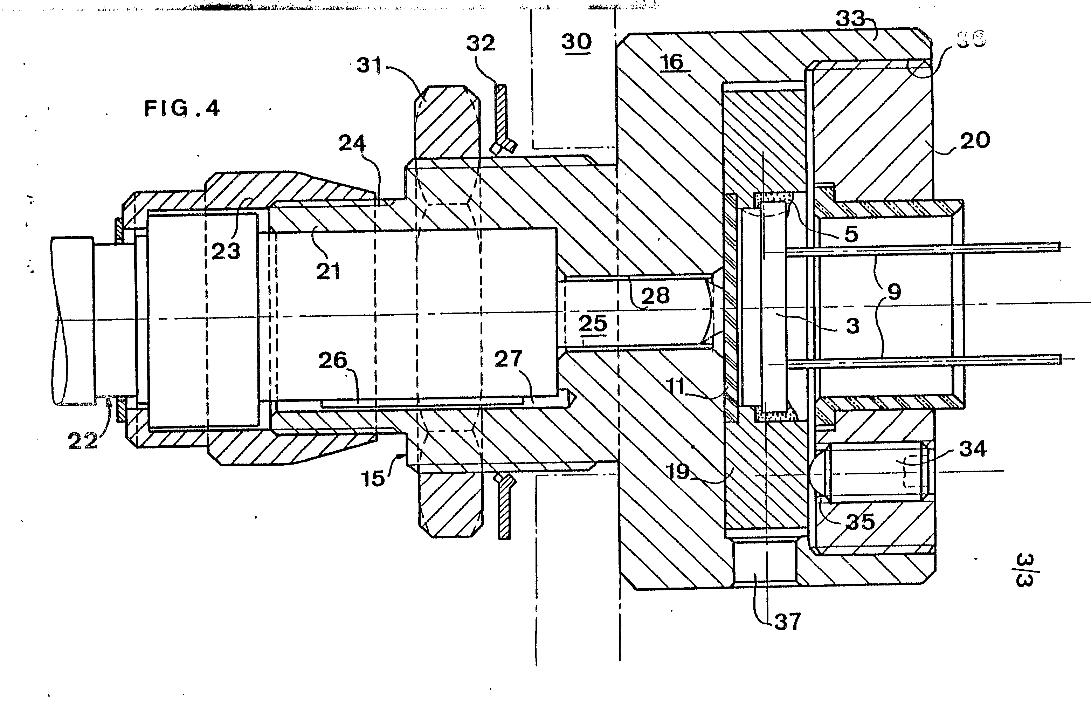

Le connecteur représenté sur la figure 4 est constitué d'une embase 15 comportant, comme décrit en

13

référence à la figure 3, une extrémité 21 de forme générale tubulaire pouvant recevoir une fiche 22 identique à celle précédemment décrite.

Pour cette raison, on ne décrira pas à nouveau les nombreux éléments identiques se retrouvant sur les deux connecteurs, et qui seront identifiés par les mêmes indices de référence. Le connecteur selon la figure 4 se distingue essentiellement de celui représenté sur la figure 3 par le fait que la partie massive 16 de l'embase 15 se prolonge d'une extrémité tubulaire 33, entourant un embout-récepteur équipé d'une photodiode, et dont le corps 19 est susceptible d'être appliqué contre l'embase 15 par des éléments de centrage filetés 34, reçus dans des perçages filetés 35 pratiqués dans un obturateur 20 vissé sur un filetage interne 36 de l'extrémité tubulaire 33. Un orifice 37, ménagé dans la partie tubulaire 33, permet le passage d'un micromanipulateur pour positionner le corps 19 de l'embout-récepteur contre l'embase 15, de sorte que le signal transmis à la photodiode par la fibre optique retenue sur l'embout 25 soit maximum, alors que l'extrémité des éléments de centrage filetés 34, saillant de l'obturateur 20 du côté de l'embase 15 n'applique pas le corps 19 contre l'embase 15. On procède ensuite au serrage des éléments de centrage 34, ce qui immobilise le corps 19 dans la position la plus favorable.

Au moyen de la photodiode selon l'invention, dérivée de matériels existants, on obtient des connecteurs de mise en oeuvre aisée, équipés d'embouts-récepteur et de fiche adaptés, d'une structure ne nécessitant que peu d'usinage précis, donc d'un coût abordable pour une utilisation à grande échelle sur chantiers.

14

R E V E N D I C A T I O N S

1/ Connecteur assurant la connexion d'une fibre optique (45) et d'une photodiode, constitué d'une embase (15), dont l'une des extrémités (21), de forme générale tubulaire, est destinée à recevoir une fiche (22), portant un embout (25), lequel présente un perçage longitudinal (57) dans lequel est reçue la fibre (45), retenue, par son extrémité, à une extrémité de l'embout (25) qui est reçue, au montage de la fiche (22) sur l'embase (15), dans un alésage central (28) de l'embase (15), l'autre extrémité (16) de l'embase (15) recevant un embout-récepteur équipé d'une photodiode dont un corps de boîtier (4), enveloppant un support (3) traversé par des bornes de contact (9) reliées à un cristal sensible (1), est fermé par une fenêtre 11, caractérisé en ce que l'embout (25), monté flottant dans la fiche (22) avec un jeu supérieur au jeu de montage de la fiche (22) dans l'embase (15) dans laquelle la fiche (22) est immobilisée en rotation, est lui-même immobilisé en rotation dans l'alésage central (28) de l'embase (15), et se trouve appliqué axialement par des moyens élastiques contre la fenêtre (11) de la photodiode de l'embout-récepteur dont la position vis-à-vis de l'embase est réglable dans un plan radial.

2/ Connecteur selon la revendication 1, caractérisé en ce que la fenêtre (1) de la photodiode est fixée par son pourtour dans une gorge circulaire (13) pratiquée directement dans le corps (19) de l'embout-récepteur, constituant simultanément le corps (14) du boîtier de la photodiode, et susceptible d'être positionné contre l'autre extré-

15

mité (16) de l'embase (15) au moyen d'éléments de centrage filetés (17 ou 35).

3/ Connecteur selon la revendication 2, caractérisé en ce que cette autre extrémité (16) de l'embase (15), également de forme tubulaire, entoure le corps (19) du boîtier de la photodiode de l'embout-récepteur et présente un filetage interne (36) sur lequel vient se visser un obturateur (20), éventuellement traversé par les deux bornes de contact (9) de la photodiode, et dans lequel ont été ménagés des perçages filetés (35) recevant des éléments de centrage filetés (34), dont l'extrémité, saillant de l'obturateur (20) du côté de l'embase (15), applique et positionne le corps (19) de l'embout-récepteur contre l'embase (15).

4/ Connecteur selon la revendication 3, caractérisé en ce qu'un orifice (37) est ménagé dans l'extrémité de forme tubulaire (33) de l'embase (15) entourant l'embout-récepteur, pour permettre le positionnement de l'embout-récepteur vis-à-vis de l'embase (15), au moyen d'un micromanipulateur, avant le serrage des éléments de centrage filetés (34).

5/ Connecteur selon la revendication 2, caractérisé en ce que le corps (19) de l'embout-récepteur présente des perçages (18) destinés à être traversés, avec un jeu important, par les éléments de centrage filetés (17).

6/ Connecteur selon la revendication 5, caractérisé en ce que ladite autre extrémité (16) de l'embase (15) présente des perçages filetés, dans lesquels sont susceptibles d'être vissés les éléments de centrage filetés (17) traversant, avec un jeu important, les perçages (18) prévus à cet effet dans le corps (19) de l'embout-récepteur.

FIG.2

FIG.1

FIG.3

0010507

FIG.4

0010507

## DOCUMENTS CONSIDERES COMME PERTINENTS

| Catégorie | Citation du document avec indication, en cas de besoin, des parties pertinentes | Revendication concernée |
|---|---|---|
| | US - A - 3 954 338 (G.F. HENNEL)<br>* Colonne 3, lignes 13-56; figure 1 * | 1,4,5 |
| | -- | |
| | FR - A - 2 356 167 (L.E.P.)<br>* Revendication 1; figure * | 1 |
| | -- | |
| | US - A - 3 932 761 (H.J. RANSEY)<br>* Revendication 1 * | 1 |
| | -- | |
| | US - A - 4 118 105 (K.J. VOIGT)<br>* Colonne 3, lignes 53-68; colonne 4, lignes 1-26; figures 1,2 * | 1 |
| | -- | |
| | US - A - 4 024 397 (S.L. WEINER)<br>* Colonne 3, lignes 27-30; figure 1 * | 2 |
| | -- | |
| | FR - A - 2 260 120 (CORNING GLASS)<br>* Page 4, lignes 6-39; page 5, lignes 1-7; figures 1,2 * | 4 |
| | -- | |
| A | DE - A - 2 755 372 (I.S.E.)<br>* Revendications 1,3 * | 1 |
| | -- | |
| E | FR - A - 2 387 517 (THOMSON)<br>* Page 2, lignes 4-10; figure 1 * | 2 |

CLASSEMENT DE LA DEMANDE (Int. Cl. 3)

G 02 B 7/26
H 01 L 31/02

DOMAINES TECHNIQUES RECHERCHES (Int. Cl. 3)

G 02 B 7/26
H 01 L 31/02

CATEGORIE DES DOCUMENTS CITES

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

| | | |
|---|---|---|
| Le présent rapport de recherche a été établi pour toutes les revendications | | |
| Lieu de la recherche<br>La Haye | Date d'achèvement de la recherche<br>25-01-1980 | Examinateur<br>PFAHLER |

OEB Form 1503.1  06.78